(19) Europäisches Patentamt
European Patent Office
Office européen des brevets

(11) **EP 2 869 468 A1**

(12) **EUROPEAN PATENT APPLICATION**

(43) Date of publication:
**06.05.2015 Bulletin 2015/19**

(51) Int Cl.:
**H03K 4/48** *(2006.01)*  **H03K 4/502** *(2006.01)*

(21) Application number: **14186645.9**

(22) Date of filing: **26.09.2014**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**

(30) Priority: **30.10.2013 US 201314066961**

(71) Applicant: **Intel Corporation**
**Santa Clara, CA 95054 (US)**

(72) Inventors:
• **Lakdawala, Hasnain**
  **Santa Clara, CA 95054 (US)**

• **Gordon, Eshel**
  **36005 Aloney Aba (IL)**
• **Degani, Ofir**
  **32812 Haifa (IL)**
• **Ravi, Ashoke**
  **Hillsboro, OR 97124 (US)**
• **Brown, Thomas W.**
  **Santa Clara, CA 95054 (US)**

(74) Representative: **Goddar, Heinz J.**
**Boehmert & Boehmert**
**Anwaltspartnerschaft mbB**
**Patentanwälte Rechtsanwälte**
**Pettenkoferstrasse 20-22**
**80336 München (DE)**

(54) **Digital voltage ramp generator**

(57)    According to some embodiments, an all digital ramp generator may use a string of series connected delays or digital to time-based circuits to perform voltage ramp generation. Thus in some embodiments conventional operational amplifier circuits and relaxation oscillators may be replaced for generating triangular ramp waveforms for DC to DC or direct time-based DC to DC converters. The use of delay lines may produce sufficient resolution for many applications. Thus time domain techniques may afford a more digital approach that scales with process technology and allows high speed operation in some embodiments. A design based on use of inverters and capacitors may scale well with process technology. The decoder and drive logic may be integrated into the voltage ramp generation in some embodiments.

FIG. 1

EP 2 869 468 A1

**Description**

Background

This relates generally to the generation of voltage ramps.

Voltage ramps are simply triangular waveforms that are useful in many applications such as the generation of pulse width modulated (PWM) signals. Pulse width modulated signals are used in a wide variety of applications including power management and displays.

Traditionally, ramp generators for pulse width modulated signals use a current source integrator. A current source integrator generally involves the use of analog components with calibrated values. In addition, the traditional solution uses a voltage domain digital-to-analog converter based on current sources, resistor ladders and the like. In such cases, the speed of the ramp is limited by the decoder and is complex when producing a large number of bits.

Brief Description Of The Drawings

Some embodiments are described with respect to the following figures:

Figure 1 is a schematic depiction of one embodiment;

Figure 2 is a schematic depiction of an interpolated low latency delay line or ring oscillator according to one embodiment;

Figure 3 is a depiction of another embodiment of a ramp generator;

Figure 4 is a depiction of another embodiment of a ramp generator;

Figure 5 includes waveforms produced at different locations by the ramp generator shown in Figure 4 according to one embodiment;

Figure 6 is a partial schematic depiction of one embodiment;

Figure 7 is a schematic depiction of another embodiment of a ramp generator;

Figure 8 is a depiction of a switching DC to DC converter according to one embodiment;

Figure 9 depicts waveforms for use in an all digital DC to DC converter or digital to time conversion according to one embodiment;

Figure 10 is a circuit schematic for a digital ramp generator for a digital to time converter or digital DC to DC converter according to one embodiment;

Figure 11 is a depiction of an analog-to-digital converter according to one embodiment;

Figure 12 is a depiction of a transmitter according to one embodiment;

Figure 13 is a system depiction for one embodiment; and

Figure 14 is a perspective view for one embodiment.

Detailed Description

According to some embodiments, an all digital ramp generator may use a string of series connected delays or digital to time-based circuits to perform voltage ramp generation. Thus in some embodiments conventional operational amplifier circuits and relaxation oscillators may be replaced for generating triangular ramp waveforms for DC to DC or direct time-based DC to DC converters. The use of delay lines may produce sufficient resolution for many applications. Thus time domain techniques may afford a more digital approach that scales with process technology and allows high speed operation in some embodiments. A design based on use of inverters and capacitors may scale well with process technology. The decoder and drive logic may be integrated into the voltage ramp generation in some embodiments.

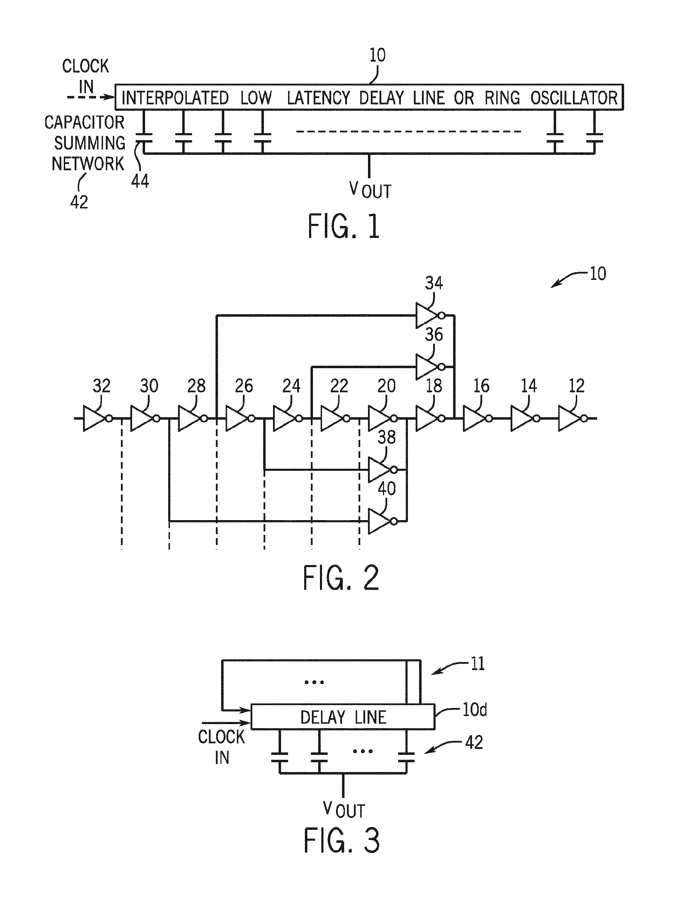

In Figure 1, a schematic diagram of a voltage ramp generator, according to one embodiment, may include an interpolated low latency delay line or ring oscillator. A delay line without interpolation provides an integer gate delay. With interpolation a delay line can provide a fractional gate delay. The clock in is shown in dashed lines since it is only used with interpolated low latency delay lines and not with ring oscillator embodiments. The delay line or ring oscillator 10 is coupled to a capacitor summing network 42 made up of an array of parallel capacitors 44 whose outputs produce the output of the ramp generator $V_{out}$, typically a triangular ramp signal.

The delay line may include a plurality of parallel connected inverter outputs (see e.g. inverters 18, 36 and 34 in Figure 2) summed together for reduced delay. Other techniques may be used including delay Verniers. The network 42 may include a plurality of capacitors each dedicated to a single inverter of the delay line for modular designs according to some embodiments.

In some embodiments, very high frequency pulse width modulated signals may be produced for power management including signals in the range of 10 MegaHertz to 1 GigaHertz. At higher frequencies it may be easier to suppress noise in the switching regulator. But with too high of a frequency, there may be switching losses.

Thus referring to Figure 2, one embodiment of an interpolated low latency delay line 10 is depicted. It includes a series of 11 inverters, 12, 14, 16, 18, 20, 22, 24, 26, 28, 30 and 32 according to one embodiment. However other numbers of series connected inverters may be used. Each stage (12, 14, 16...) may include the plurality of parallel connected inverters. The inverter 40 is tapped at the output of the inverter 30, the inverter 38 is tapped at the output of inverter 26, the inverter 34 is tapped at the output of inverter 28 and inverter 36 is tapped at the output of inverter 24. Inverters 34 and 36 are shorted to the output of inverter 18 while inverters 38 and 40 are shorted to the output of inverter 20.

As a result, an interpolated delay line may be implemented in some embodiments. When a clock edge from a clock in signal is propagated through the delay line, the voltage at each of the capacitor 44 inputs is changed, but with a delay.

In systems without an external clock, a ring oscillator may be implemented. The oscillator may be part of a phase locked loop (PLL) or a delay locked loop (DLL) structure. The PLL or DLL structure may be part of a power management unit clock generator in some embodiments. Thus referring to Figure 3, the delay line 10d may include a plurality of feedback lines 11 between one or more of the series connected inverters 12-32 of Figure 2 for example. The capacitor summing network 42 may be unchanged from Figure 1.

In some embodiments the interpolated delay line may be the result of the arrangement between the output of the inverter 18 and the outputs from the inverters 34 and 36. Note that the inverters 34 and 36 receive their inputs from stages previous to the input to the inverter 18. Thus there are three inverters whose outputs are shorted together. The input for one inverter of the three comes from the previous stage, the inverter for another inverter of the three comes from three stages before and the input for the third inverter comes from five stages before. While there is no need for a particular number of inverters, any number of inverters in parallel can be used to produce the interpolated delay. Thus what happens is the signal starts transitioning even before it would otherwise, because it is receiving inputs from further up in the chain. Normally, because of the delays in the cell, as the signal propagates down the line, the transition occurs successively. For example if you want the inverter 22 to toggle before the inverter 24 starts transitioning, the inverter 24 toggles and the inverter 26 starts transitioning. The inverter 26 output starts transitioning even as the inverter 22 starts transitioning. This results in interpolation between delays and allows adjustment of the final resolution of delays. Then the voltage ramp may mimic an ideal triangular wave more closely without so much filtering in the summing network or in the output of the DC to DC converter when removing noise, in some embodiments.

There are many improvements that can be made in some embodiments. If the inverter delays are good enough due to advanced process technology, then a single series connected string of inverters may be sufficient in some embodiments.

The use of delays or digital time based circuits to do voltage ramp generation may provide an all digital ramp in some embodiments. If finer resolution is needed, then a variety of other techniques may be used. Generally there are three options. If a clock in is used then a delay line is used, and if there is no clock in then a ring oscillator is used. Precise spectral control in a third embodiment of the output voltage may be accomplished by embedding the delay line or ring oscillator in PLL or DLL as shown in Figure 3.

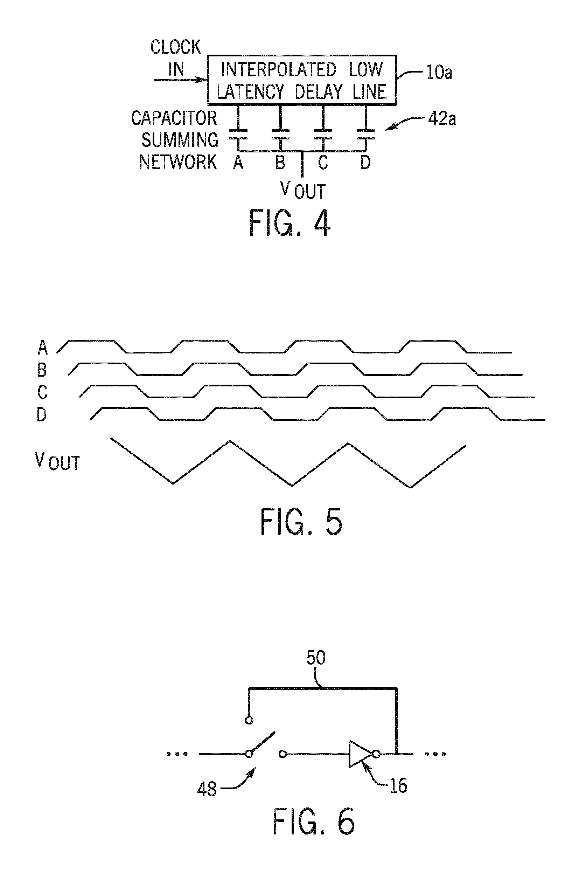

Thus a simple example is shown in Figure 4, using a delay line for a small circuit. The nodes A, B, C and D have their outputs depicted in Figure 5. Note that each output is delayed relative to its predecessor. And voltage out ($V_{out}$) is also depicted in Figure 5. The capacitors are charged one by one, by the clock in edges. The charging of the delay cell is a smooth ramp with limited slope. The falling edges of the waveforms enforce the falling of the output voltage ramp. This may work better if the delay is embedded in the ring oscillator or in the DLL, but in general if the delay is long enough to span integer periods, the ramp is preserved.

The length of the delay line can be adjusted by controlling the length of the line of series connected inverters by digitally disabling extra inverters, for example using the switch 48 which either opens or closes the bypass 50 around the inverter 16 as shown in Figure 6. The switch 48 adjusts the number of inverters and one can also control the delay by modulating the drive strength of the capacitive load or by controlling the number of stages that drive the same node.

Generally less stages driving the same node means less interpolation and the delay is larger but with more stages there is more interpolation and the delay is shorter. Other techniques may also be used to adjust the interpolation and/or delay. Also, additional stages may ultimately consume more power without giving more resolution at some point.

Adjustments to the amount of delay or interpolation can be made by changing the number of devices in parallel, the drive strength of each device or the load that is driven into.

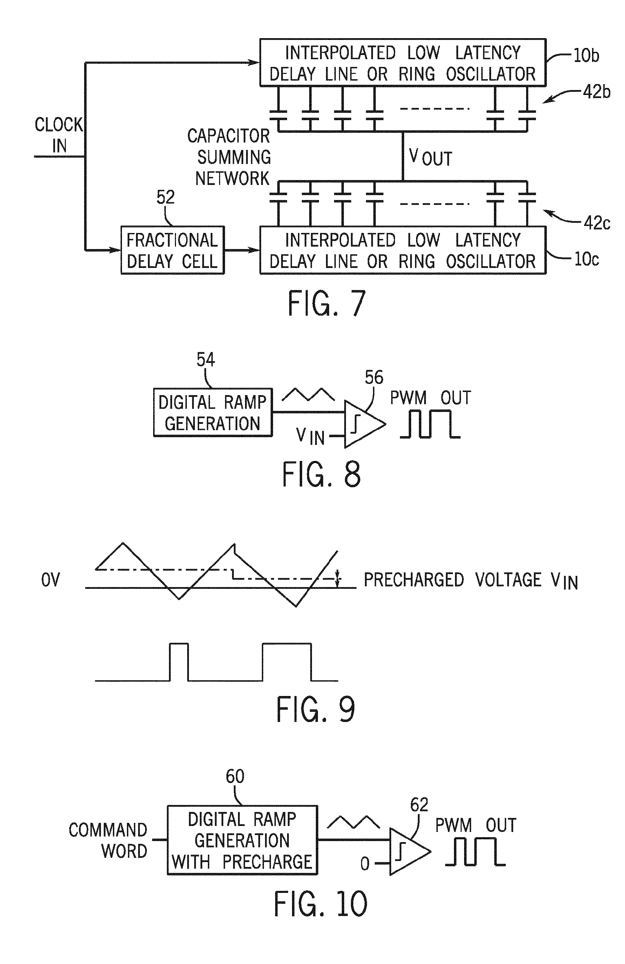

Thus as shown in Figure 7 interleaving and interpolation may be done where the output voltage is taken between the ramp generators made up of the delay line or ring oscillator 10b, the summing network 42b, and the parallel connected delay line or ring oscillator 10c and the summing network 42c. The clock is connected to both ramp generators as well as to a fractional delay cell 52. The fractional delay cell may be an interpolating cell with a half delay in one embodiment. For example if the delay in each of the two lines is x picoseconds, and one cannot go any lower because of process limitations or power consumption, there the circuit design allows an even lower delay. As shown in Figure 7, interpolation between the two delay lines is obtained by putting an x picosecond delay between the two delay lines in the cell 52. Now the output delay is less than x picoseconds (and ideally is .5x picoseconds) because you have interpolated between the two delay lines. The same principle can be extended to more than two parallel lines to further reduce the delay in some embodiments.

There are some specific implementations that may be able to benefit from the ramp generator. For example, a regular switching DC to DC converter may use a ramp generator as described herein. In a regular control loop of a fast DC to DC converter, an input voltage Vin is mapped to a ramp as shown in Figure 8. Figure 8 shows a fully integrated voltage regulator-like application. The digital ramp generation 54 may in accordance with the one embodiment provide a ramp signal to the comparator 56 that also receives the input voltage Vin to produce a pulse width modulated (PWM) output as depicted.

In a regular analog to DC converter there is a block that is a comparator where you compare the input to an analog ramp and the output is a pulse width modulated signal. Now the ramp can be generated digitally.

Another application is an all digital DC to DC converter, for example for digital to time conversion. If an all digital DC to DC converter is used then the command word or input voltage as depicted in Figure 10 is precharged on the capacitors making up the summing network 42. The precharged ramp generator 60 produces an output to comparator 62. The comparator also receives a zero, does a comparison, and outputs a PWM signal.

Then the ramp is available relative to the input and the duty cycle is determined by the zero crossing of the inverter. This is shown in Figure 9. The zero crossing (top plot in Figure 9) produces a pulse (bottom plot in Figure 9) in the pulse width modulated output. Instead of feeding the input voltage to the comparator, the capacitors are precharged to the correct voltage in the capacitor's summing network.

The precharging of the capacitors in the summing network can be done in various ways. For example, the capacitors of the capacitor summing network may be precharged using a binary weighting scheme. As another example, the capacitors may be precharged using separate capacitive digital-to-analog converters to generate a Vin as described in connection with the regular switching DC to DC converter application above.

In a binary weighting scheme, the capacitors may have the same weight but one can change the weights using filtering in the combining network. The waveform goes through the delays and then through the weighted combiner that acts like a finite impulse response (FIR) filter. But one can also combine the capacitor outputs with a binary capacitor bank or a scaled capacitor bank, for example in an analog to digital converter network, using binary weighted capacitor banks.

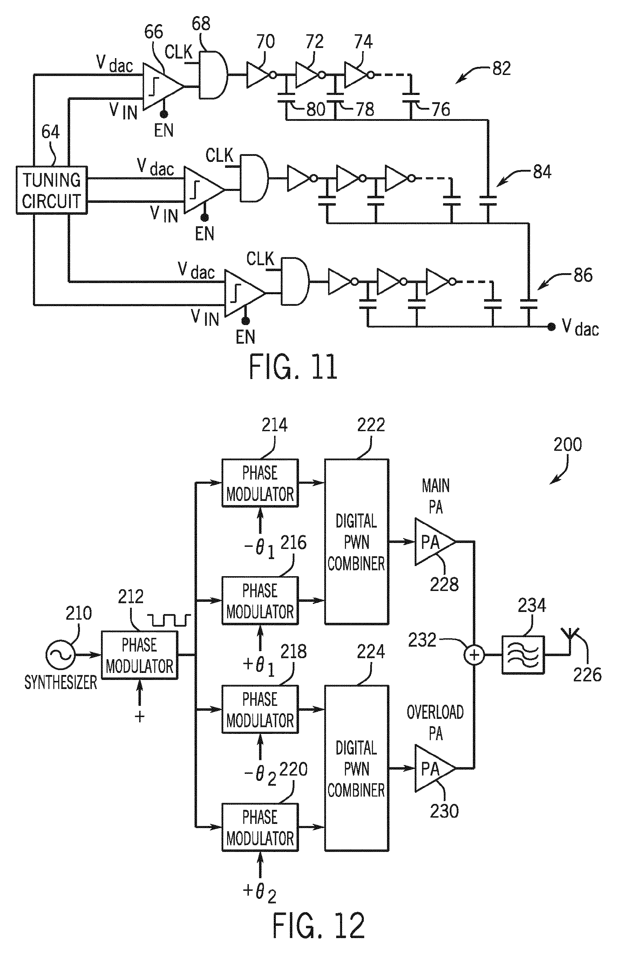

A third application is for analog to digital converters. For single slope analog to digital converters, several binary weighted digital ramp generators can be cascaded with a control loop that stops the input clock to each bank, such that the input is resolved as shown in Figure 11. The parallel digital ramp generator banks 82, 84, and 86 are converted to tuning circuit 64. Each bank includes a comparator 66 that receives an input voltage Vin and a digital-to-analog conversion voltage $V_{dac}$. An AND circuit 68 receives the comparator output and ANDs it with a clock. The output is passed to a delay line with inverters 70, 72, and 74 and comparator summing network with capacitors 76, 78, and 80. Each successive bank is coupled via a capacitor to the next bank.

This circuit may be useful for window analog to digital converters of a digital DC to DC converter. The values of the capacitors in each bank may, in one embodiment, be 1x, 2x, and 4x values. The three networks of delay elements with capacitive combiners have their outputs combined. This may be advantageous in a data converter or a single slope converter where you extract a most significant bit, then a next most significant bit, and so one until you get to the least significant bit. Because you extract a bit at a time, each bit has a binary weight relative to the previous bit and the next bit. With binary weighting, these banks make it easier to implement the bit extraction.

In some embodiments each bank need not have the exact value it should have. For example due to process errors or limitations, the banks may have capacitors that are not exactly as specified. For example the bank 82 may have capacitors at 1 picofarad and the bank 84 is supposed to have capacitors at 2 picofarads. But suppose they are really 1.9 picofarads. The interpolation may be used adjusted to compensate for the capacitor variation. As another example the time delays between the signals driving the banks may be adjusted to compensate for the error using the tuning or tuning or calibrating circuit 64 which changes the input values to self compensate once it is known what compensation is needed. Thus a calibration scheme may be used to compensate for the process variations. The calibration scheme may run in the foreground or the background using well known techniques.

Referring now to Figure 12, a block diagram of transmitter that may use the ramp generator in the power amplifiers 228 and 230 utilizing subranging for two-path pulse-position and pulse-width modulation out-phasing in accordance with one or more embodiments will be discussed. A typical out-phasing modulator has a distribution of theta $\theta$ that is a Raleigh distribution such as for a typical orthogonal frequency division multiplexing (OFDM) modulated signal. A typical switching power amplifier has higher efficiency when the duty cycle of the input to the pulse-width modulator is higher valued since the portion of harmonic content is lower. As a result, a conventional pulse-width modulation (PWM) switching power amplifier (PA) operates in an area of lower efficiency most of the time, thereby degrading the temporal efficiency. Transmitter 200 of Figure 12 overcomes this issue by having multiple power amplifiers, for example, main PA 228 and overload PA 230 that are driven. The signals for the two power amplifiers are generated via phase mapping as discussed, below.

As shown in Figure 12, transmitter 200 includes synthesizer 210 to generate a higher frequency local-oscillator (LO) signal that is provided to phase modulator 212. Phase modulator 212 phase modulates the LO signal using $\Phi$ as a control signal to provide a first modulated output that is split into four paths and provided to four phase modulators 214, 216, 218, and 220. Phase modulator 214 receives $-\theta_1$ as a control signal, phase modulator 216 receives $+\theta_1$ as a control signal, phase modulator 216 receives $-\theta_2$ as a control signal, and phase modulator 220 receives $+\theta_2$ as a control signal. The phase-modulated outputs of phase modulator 214 and phase modulator 216 are provided to a first digital pulse width modulation (PWM) combiner 222, and the phase-modulated outputs of phase modulator 218 and phase modulator 220 are provided to a second digital pulse-width modulation (PWM) combiner 224. The output of the first PWM combiner 222 is a position and pulse-width modulated output that is provided to main PA 228, and the output of second PWM combiner 224 is a pulse-position and pulse-width modulated output that is provided to overload PA 230. The outputs of main PA 228 and overload PA are combined via summing element 232 which is coupled to impedance matching network 234 and antenna 226 for transmission as an OFDM signal.

The architecture of transmitter 200 of Figure 12 illustrates a sub-ranging technique applied to a conventional two-path pulse position and pulse-width modulation (P3WM) out-phasing power amplifier scheme in which $\Phi$ and $\theta$ are modulated directly. The entire range, or nearly the entire range, of $\theta$ is divided in to more than one section such that each power amplifier 228 and 230 is driven by separately modulated signals with phases $\theta_1$ and $\theta_2$. In one or more embodiments, the baseband data signals are decomposed for the two power amplifier embodiment shown in Figure 12 in the following manner. The baseband data signal is represented as:

$$y_0(t) = \frac{A}{2} cos(wt + \phi(t) - \theta_1(t)) + \frac{A}{2} cos(wt + \phi(t) + \theta_1(t)) +$$

$$\frac{A}{2} cos(wt + \phi(t) - \theta_2(t)) + \frac{A}{2} cos(wt + \phi(t) + \theta_2(t))$$

$$y_0(t) = A cos(\theta_1(t) cos(wt + \phi(t)) + A cos(0_2(t)) cos(wt + \phi(t))$$

In one or more embodiments, the decomposition algorithm should satisfy the following equation:

$$2 cos(\theta(t)) = cos(\theta_1(t)) + cos(\theta_2(t))$$

in which, $\theta$ is the phase of an out-phasing scheme. By utilizing a proper choice of $\theta_1$ and $\theta_2$, main PA 228 is on most or all of the time and overload PA 230 is used only occasionally to service any needed peak power. Such an arrangement as shown in Figure 12 does not require, for example, radio frequency (RF) phase shifters. In one or more embodiments, one possible mapping of $\theta$ and $\theta_1$ and $\theta_2$ for a two power amplifier arrangement as shown in Figure 12 may be as follows:

$$\text{For } \theta < 60°, \theta_2 = 90°:$$

$$\theta_1 \text{ ranges from } 90° \text{ to } 0°$$

$$\cos(\theta_1(t)) = 2\cos\theta(t)$$

$$\text{For } 60° < \theta < 90°:$$

$$\theta_1 = 0° \text{ and } \theta_2 \text{ is}$$

$$\cos(\theta_2(t)) = 2\cos(\theta(t)) - 1$$

The current or the power at the outputs of the two separately driven power amplifiers, main PA 228 and overload PA 230, is summed at the output via a power combining technique that may include, but is not limited to current summing and RF power combining using passive elements, although the scope of the claimed subject matter is not limited in this respect. The mapping of $\theta$ to $\theta_1$ and $\theta_2$, can be implemented using any one or more of the following techniques: modification of the coordinated rotation digital computer (CORDIC) algorithm to generate $\theta_1$ and $\theta_2$, directly; generation of mapping of $\theta$ to $\theta_1$ and $\theta_2$ via utilization of a look up table; and/or generation of $\theta$ to $\theta_1$ and $\theta_2$ using a feedback signal to avoid distortion during the overlap of the modulation angles, although the scope of the claimed subject matter is not limited in these respects. Although transmitter 200 of Figure 12 illustrates a two power amplifier example, transmitter 200 may be expanded any number of power amplifiers with different $P^3$WM driven power amplifiers used for different segments of the dynamic range, and the scope of the claimed subject matter is not limited in this respect.

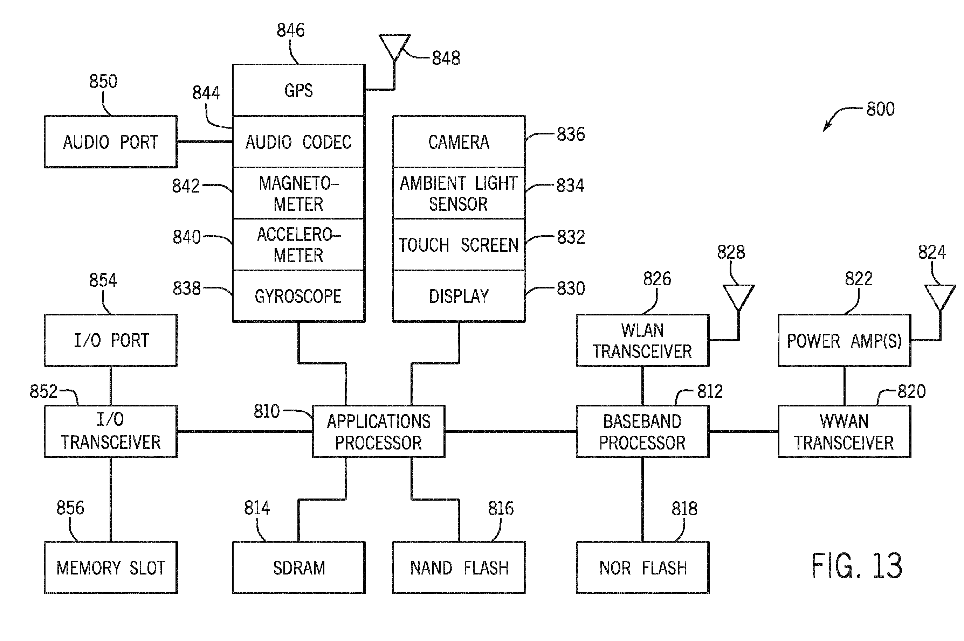

Referring now to Figure 13, a block diagram of an information handling system using the transmitter of Figure 12 in accordance with one or more embodiments will be discussed. Information handling system 800 of Figure 13 may tangibly embody one or more of any of the network elements or devices as shown in and described with respect to Figures 1 to 12, with greater or fewer components depending on the hardware specifications of the particular device or network element. Although information handling system 800 represents one example of several types of computing platforms, information handling system 800 may include more or fewer elements and/or different arrangements of elements than shown in Figure 13, and the scope of the claimed subject matter is not limited in these respects.

In one or more embodiments, information handling system 800 may include an applications processor 810 and a baseband processor 812. Applications processor 810 may be utilized as a general purpose processor to run applications and the various subsystems for information handling system 800. Applications processor 810 may include a single core or alternatively may include multiple processing cores wherein one or more of the cores may comprise a digital signal processor or digital signal processing core. Furthermore, applications processor 810 may include a graphics processor or coprocessor disposed on the same chip, or alternatively a graphics processor coupled to applications processor 810 may comprise a separate, discrete graphics chip. Applications processor 810 may include on board memory such as cache memory, and further may be coupled to external memory devices such as synchronous dynamic random access memory (SDRAM) 814 for storing and/or executing applications during operation, and NAND flash 816 for storing applications and/or data even when information handling system 800 is powered off. In general, any of the memory devices of information handling system 800 may comprise an article of manufacture having instructions stored thereon that cause a processor of the information handling system 800 to execute the instructions to implement any method or process wholly or in part as described herein. Baseband processor 812 may control the broadband radio functions for information handling system 800. Baseband processor 812 may store code for controlling such broadband radio functions in a NOR flash 818. Baseband processor 812 controls a wireless wide area network (WWAN) transceiver 820 which is used for modulating and/or demodulating broadband network signals, for example for communicating via a Wi-Fi, LTE or WiMAX network or the like as discussed herein. The WWAN transceiver 820 couples to one or more power amps 822 respectively coupled to one or more antennas 824 for sending and receiving radio-frequency signals via the WWAN broadband network. The baseband processor 812 also may control a wireless local area network (WLAN) transceiver 826 coupled to one or more suitable antennas 828 and which may be capable of communicating via a Wi-Fi, Bluetooth, and/or an amplitude modulation (AM) or frequency modulation (FM) radio standard including an IEEE 802.11 a/b/g/n standard or the like. It should be noted that these are merely example implementations for applications processor 810 and baseband processor 812, and the scope of the claimed subject matter is not limited in these respects. For example, any one or more of SDRAM 814, NAND flash 816 and/or NOR flash 818 may comprise other types of memory technology such as magnetic memory, chalcogenide memory, phase change memory, or ovonic memory, and the scope of the claimed subject matter is not limited in this respect.

In one or more embodiments, applications processor 810 may drive a display 830 for displaying various information or data, and may further receive touch input from a user via a touch screen 832 for example via a finger or a stylus. An ambient light sensor 834 may be utilized to detect an amount of ambient light in which information handling system 800 is operating, for example to control a brightness or contrast value for display 830 as a function of the intensity of ambient light detected by ambient light sensor 834. One or more cameras 836 may be utilized to capture images that are processed by applications processor 810 and/or at least temporarily stored in NAND flash 816. Furthermore, applications processor may couple to a gyroscope 838, accelerometer 840, magnetometer 842, audio coder/decoder (CODEC) 844, and/or global positioning system (GPS) controller 846 coupled to an appropriate GPS antenna 848, for detection of various environmental properties including location, movement, and/or orientation of information handling system 800. Alternatively, controller 846 may comprise a Global Navigation Satellite System (GNSS) controller. Audio CODEC 844 may be coupled to one or more audio ports 850 to provide microphone input and speaker outputs either via internal devices and/or via external devices coupled to information handling system via the audio ports 850, for example via a headphone and microphone jack. In addition, applications processor 810 may couple to one or more input/output (I/O) transceivers 852 to couple to one or more I/O ports 854 such as a universal serial bus (USB) port, a high-definition multimedia interface (HDMI) port, a serial port, and so on. Furthermore, one or more of the I/O transceivers 852 may couple to one or more memory slots 856 for optional removable memory such as secure digital (SD) card or a subscriber identity module (SIM) card, although the scope of the claimed subject matter is not limited in these respects.

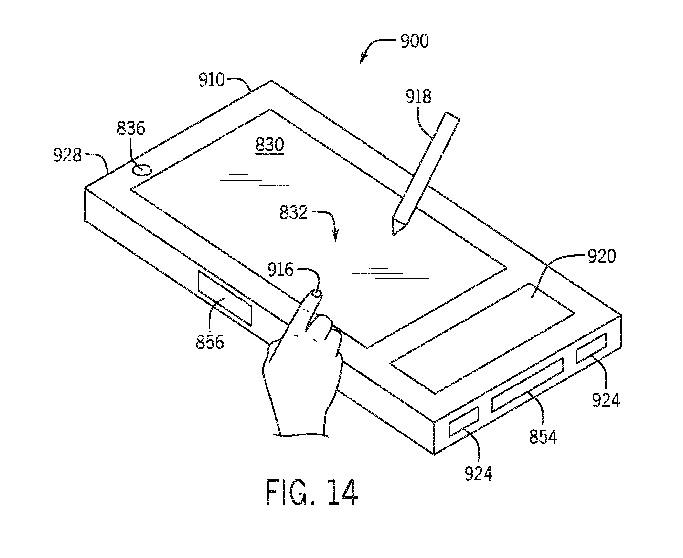

Referring now to Figure 14 , an isometric view of an information handling system 900 of Figure 13 that optionally may include a touch screen in accordance with one or more embodiments will be discussed. Figure 14 shows an example implementation of information handling system 800 of Figure 13 tangibly embodied as a cellular telephone, smartphone, or tablet type device or the like. The information handling system 900 may comprise a housing 910 having a display 830 which may include a touch screen 832 for receiving tactile input control and commands via a finger or fingers 916 of a user and/or a via stylus 918 to control one or more applications processors 810. The housing 910 may house one or more components of information handling system 800, for example one or more applications processors 810, one or more of SDRAM 814, NAND flash 816, NOR flash 818, baseband processor 812, and/or WWAN transceiver 820. The information handling system 800 further may optionally include a physical actuator area 920 which may comprise a keyboard or buttons for controlling information handling system via one or more buttons or switches. The information handling system 900 may also include a memory port or slot 856 for receiving non-volatile memory such as flash memory, for example in the form of a secure digital (SD) card or a subscriber identity module (SIM) card. Optionally, the information handling system 800 may further include one or more speakers and/or microphones 924 and a connection port 854 for connecting the information handling system 900 to another electronic device, dock, display, battery charger, and so on. In addition, information handling system 800 may include a headphone or speaker jack 928 and one or more cameras 836 on one or more sides of the housing 910. It should be noted that the information handling system 800 of Figure 14 may include more or fewer elements than shown, in various arrangements, and the scope of the claimed subject matter is not limited in this respect.

The following clauses and/or examples pertain to further embodiments:

One example embodiment may be an apparatus comprising a digital delay line, and a digital capacitor summing network coupled to said delay line to output a ramp waveform. The apparatus may also include said delay line is a ring oscillator. The apparatus may also include said delay line is an interpolated delay line. The apparatus may include said delay line is part of a phase locked loop or a delay locked loop. The apparatus may include said delay line includes an inverter string having a number of inverters and a circuit to tune the delay. The apparatus may include said circuit to change the number of inverters. The apparatus may include at least two parallel connected ramp generators and a fractional delay cell. The apparatus may include a comparator coupled to said capacitor summing network. The apparatus may include a tuning circuit coupled to an input to said delay line, said circuit to adapt the input to account for process variations in said network. The apparatus may include a precharged network. The apparatus may include a binary weighting scheme. The apparatus may include an antenna, touch screen and an applications processor.

Another example embodiment may be a method comprising generating a plurality of delayed outputs, using a capacitor summing network to sum said outputs, and generating a ramp waveform from said summed outputs. The method may also include using a ring oscillator to generate said outputs. The method may also include using an interpolated delay line to generate said outputs. The method may also include tuning the delay. The method may also include tuning the delay by changing a number of inverters in an interpolated delay line. The method may also include using a tuning circuit coupled to an input to said delay line, to adapt the input to account for process variations in said network. The method may also include using at least two parallel connected ramp generators and a fractional delay cell. The method may also include precharging the capacitor summing network.

In another example embodiment an apparatus comprising a device including an interpolated delay line or a ring oscillator, and a capacitive summing network coupled to said device. The apparatus may include said delay line is part of a phase locked loop or a delay locked loop. The apparatus may include said delay line includes an inverter string having a number of inverters and a circuit to tune the delay. The apparatus may include said circuit to change the number of inverters. The apparatus may include a comparator coupled to said capacitor summing network.

References throughout this specification to "one embodiment" or "an embodiment" mean that a particular feature, structure, or characteristic described in connection with the embodiment is included in at least one implementation encompassed within the present disclosure. Thus, appearances of the phrase "one embodiment" or "in an embodiment" are not necessarily referring to the same embodiment. Furthermore, the particular features, structures, or characteristics may be instituted in other suitable forms other than the particular embodiment illustrated and all such forms may be encompassed within the claims of the present application.

While a limited number of embodiments have been described, those skilled in the art will appreciate numerous modifications and variations therefrom. It is intended that the appended claims cover all such modifications and variations as fall within the true spirit and scope of this disclosure.

**Claims**

1. An apparatus comprising:

   a digital delay line; and
   a digital capacitor summing network coupled to said delay line to output a ramp waveform.

2. The apparatus of claim 1 wherein said delay line is a ring oscillator.

3. The apparatus of claim 1 wherein said delay line is an interpolated delay line.

4. The apparatus of claim 1 wherein said delay line is part of a phase locked loop or a delay locked loop.

5. The apparatus of claim 1 wherein said delay line includes an inverter string having a number of inverters and a circuit to tune the delay.

6. The apparatus of claim 5 said circuit to change the number of inverters.

7. The apparatus of claim 1 including at least two parallel connected ramp generators and a fractional delay cell.

8. The apparatus of claim 1 including a comparator coupled to said capacitor summing network.

9. The apparatus of claim 1 including a tuning circuit coupled to an input to said delay line, said circuit to adapt the input to account for process variations in said network.

10. The apparatus of claim 1 including a precharged network.

11. The apparatus of claim 10 including a binary weighting scheme.

12. The apparatus of claim 1 including an antenna, touch screen and an applications processor.

13. A method comprising:

   generating a plurality of delayed outputs;
   using a capacitor summing network to sum said outputs; and
   generating a ramp waveform from said summed outputs.

14. The method of claim 13 including using a ring oscillator to generate said outputs.

**15.** Machine-readable storage including machine-readable instructions, when executed, to implement a method or realize an apparatus as claimed in any preceding claim.

FIG. 1

FIG. 2

FIG. 3

FIG. 4

FIG. 5

FIG. 6

INTERPOLATED LOW LATENCY
DELAY LINE OR RING OSCILLATOR ─10b

─42b

CLOCK
IN

CAPACITOR
SUMMING
NETWORK

V OUT

52

FRACTIONAL
DELAY CELL

─42c

INTERPOLATED LOW LATENCY
DELAY LINE OR RING OSCILLATOR ─10c

FIG. 7

54

DIGITAL RAMP
GENERATION

56 PWM OUT

V IN

FIG. 8

0V                PRECHARGED VOLTAGE V IN

FIG. 9

60

COMMAND
WORD

DIGITAL RAMP
GENERATION
WITH PRECHARGE

62 PWM OUT

0

FIG. 10

FIG. 11

FIG. 12

FIG. 13

EP 2 869 468 A1

FIG. 14

**Europäisches Patentamt**
**European Patent Office**
**Office européen des brevets**

# EUROPEAN SEARCH REPORT

Application Number

EP 14 18 6645

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | CRONIN D ET AL: "Intelligent System for Optimal Hold-Off Time Selection in an Active Quench and Reset IC", IEEE JOURNAL OF SELECTED TOPICS IN QUANTUM ELECTRONICS, IEEE SERVICE CENTER, PISCATAWAY, NJ, US, vol. 13, no. 4, 1 July 2007 (2007-07-01), pages 911-918, XP011192399, ISSN: 1077-260X, DOI: 10.1109/JSTQE.2007.902087 * page 913; figures 2,3,4(a),4(b) * ----- | 1-15 | INV. H03K4/48 H03K4/502 |
| A | PUI-TAK SO ET AL: "Ramp Voltage Supply using Adiabatic Charging Principle", CONFERENCE PROCEEDINGS / IEEE INTERNATIONAL SYMPOSIUM ON CIRCUITS AND SYSTEMS (ISCAS) : MAY 23 - 26, 2005, INTERNATIONAL CONFERENCE CENTER, KOBE, JAPAN, IEEE SERVICE CENTER, PISCATAWAY, NJ, 23 May 2005 (2005-05-23), pages 2152-2155, XP010816011, DOI: 10.1109/ISCAS.2005.1465046 ISBN: 978-0-7803-8834-5 * page 2153, left-hand column - page 2154, left-hand column * ----- | 1-15 | |
| | | | TECHNICAL FIELDS SEARCHED (IPC) H03K |

The present search report has been drawn up for all claims

| Place of search | Date of completion of the search | Examiner |
|---|---|---|
| Munich | 2 March 2015 | Mesplede, Delphine |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)